# EUROPÄISCHE PATENTSCHRIFT

(11) **EP 3 787 043 B1**
(45) Veröffentlichungstag und Bekanntmachung des Hinweises auf die Patenterteilung: **04.03.2026**
(21) Anmeldenummer: 20000293.9
(22) Anmeldetag: 17.08.2020
(51) Int. Cl.: H10F 10/142, H10F 77/20, H10F 77/30

(54) **PASSIVIERUNGSVERFAHREN FÜR EIN DURCHGANGSLOCH EINER HALBLEITERSCHEIBE**
PASSIVATION METHOD FOR A THROUGH HOLE OF A SEMICONDUCTOR WAFER
PROCÉDÉ DE PASSIVATION POUR UN TROU TRAVERSANT D'UNE PLAQUE SEMI-CONDUCTRICE

(30) Priorität: 29.08.2019 DE 102019006097
(43) Veröffentlichungstag der Anmeldung: 03.03.2021
(73) Patentinhaber: AZUR SPACE Solar Power GmbH, 74072 Heilbronn (DE)
(72) Erfinder: Frey, Alexander, 74081 Heilbronn (DE)
(74) Vertreter: Koch Müller Patentanwaltsgesellschaft mbH

(56) Entgegenhaltungen:
- EP-A2- 0 528 311
- EP-A2- 1 715 529
- WO-A1-2020/014499
- WO-A1-89/05521
- US-A1- 2013 263 920
- US-A1- 2014 048 128
- US-A1- 2017 213 922
- US-A1- 2017 345 955
- YOO H ET AL: "Development of coplanar back contact for large area, thin, GaAs/Ge solar cells", PROCEEDINGS OF THE PHOTOVOLTAIC SPECIALISTS CONFERENCE. LAS VEGAS, OCT. 7 - 11, 1991; [PROCEEDINGS OF THE PHOTOVOLTAIC SPECIALISTS CONFERENCE], NEW YORK, IEEE, US, vol. CONF. 22, 7 October 1991 (1991-10-07), pages 1463 - 1468, XP010039150, ISBN: 978-0-87942-636-1, DOI: 10.1109/PVSC.1991.169447
- MATHIEU DE LAFONTAINE ET AL.: "Via Sidewall Insulation for Through Cell via Contacts", AIP CONVERENCE PROCEEDINGS, vol. 1881, 2017, pages 040002
- DE LAFONTAINE MATHIEU ET AL: "Influence of plasma process on III-V/Ge multijunction solar cell via etching", SOLAR ENERGY MATERIALS AND SOLAR CELLS, vol. 195, 4 March 2019 (2019-03-04), pages 49 - 54, XP085651399, ISSN: 0927-0248, DOI: 10.1016/J.SOLMAT.2019.01.048

## Beschreibung

Die Erfindung betrifft ein Passivierungsverfahren für ein Durchgangsloch einer Halbleiterscheibe.

Um die Abschattung der Vorderseite einer Solarzelle zu reduzieren, ist es möglich, sowohl die positive als auch die negative externe Kontaktfläche auf der Rückseite anzuordnen. Bei sogenannten Metal Wrap Through (MWT) - Solarzellen wird die Solarzellenvorderseite beispielsweise durch eine Durchgangskontaktöffnung von der Rückseite aus kontaktiert.

Wesentlich ist allerdings, dass die Kontaktmetallisierung innerhalb des Durchgangskontaktlochs gegenüber allen Teilzellen zuverlässig isoliert ist. Voraussetzung für eine zuverlässige geschlossene Isolationsschicht ist jedoch eine möglichst glatte und hinterschneidungsfreie Seitenwand im Bereich der Durchgangskontaktöffnung.

Aus "Via Sidewall Insulation for Through Cell via Contacts", Mathieu de Lafontaine et al., AIP Converence Proceedings 1881, 040002 (2017), doi: 10.1063/1.5001424 ist ein Testverfahren bekannt, um die Qualität einer Isolationsschicht auf der Seitenwand eines in einen Solarzellenstapel hinein reichenden Lochs zu testen. Untersucht werden SiO₂ Schichten, welche entweder mittels plasmaunterstützter Gasphasenabscheidung oder mittels plasmaunterstützter Atomlagenabscheidung auf die Oberseite und die Seitenwand mehrerer Löcher aufgebracht worden sind. Die Löcher sind mittels eines Trockenätzprozesses erzeugt worden. Es zeigte sich, dass 40% der mittels Gasphasenabscheidung erzeugten Isolationsschichten Defekte aufweisen.

Aus De Lafontaine M et al "Influence of plasma process on III-V / Ge multijunction solar cell via etching", Solar Energy materials and Solar Cells, Bd. 195, S.49 -54, 04. März 2019, XP0856651399 sind Untersuchungen zu Strahlenschäden beim Plasmaätzen von III-V/ Ge Solarzellen bekannt.

Des Weiteren sind aus der US 2017/345955 A1, der US 2017/213922, der US 2013/263920 A1, der EP 1 715 529 A2, der US 2014/048128 A1, der WO 89/05521 A1, der EP 0 528 311 A2, aus YOO H ET AL: "Development of coplanar back contact for large area, thin, GaAs/Ge solar cells", PROCEEDINGS OF THE PHOTOVOLTAIC SPECIALISTS CONFERENCE. LAS VEGAS, OCT. 7 - 11, 1991, NEW YORK, IEEE, US, Bd. CONF. 22, 7. Oktober 1991, Seiten 1463-1468 und der WO 2020/014499 A1 weitere Solarzellenanordnungen bekannt.

Vor diesem Hintergrund besteht die Aufgabe der Erfindung darin, eine Vorrichtung anzugeben, die den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Passivierungsverfahren für ein Durchgangsloch einer Halbleiterscheibe bereitgestellt, mindestens umfassend die Schritte:
Bereitstellen einer Halbleiterscheibe mit einer Oberseite, einer Unterseite und umfassend mehrere Solarzellenstapel, wobei jeder Solarzellenstapel ein die Unterseite der Halbleiterscheibe ausbildendes Ge-Substrat, eine Ge-Teilzelle, mindestens zwei III-V-Teilzellen in der genannten Reihenfolge und mindestens eine von der Oberseite zu der Unterseite der Halbleiterscheibe reichende Durchgangsöffnung mit zusammenhängender Seitenwand und einem im Querschnitt ovalen Umfang aufweist.

Aufbringen einer dielektrischen Isolationsschicht mittels chemischer Gasphasenabscheidung auf die Oberseite der Halbleiterscheibe, die Unterseite der Halbleiterscheibe und die Seitenwand der Durchgangsöffnung.

Es versteht sich, dass die einzelnen Teilzellen der Solarzellenstapel jeweils einen pn-Übergang aufweisen und die auf das Substrat folgenden Schichten epitaktisch aufeinander erzeugt und/oder mittels Wafer-Bond miteinander verbunden sind.

Außerdem versteht es sich, dass eine Ge-Teilzelle Germanium aufweist oder aus Germanium besteht, wobei auch eine aus Germanium bestehende Schicht gegebenenfalls zusätzlich zu dem Germanium noch weitere Stoffe, Insbesondere Dotierstoffe, aber auch Verunreinigungen enthält.

Entsprechendes gilt auch für die III-V-Teilzellen, welche ein oder mehrere Materialien der III. sowie der V. Hauptgruppe aufweisen oder aus solchen Materialien bestehen.

Mittels Gasphasenabscheidung ist es möglich eine konforme Schichtabscheldung zu erreichen, so werden nicht nur die Oberseite und die Unterseite, sondern auch die jeweils angrenzenden Bereiche der Seitenfläche der Durchgangsöffnung vollflächig beschichtet.

Die vollflächige beidseitige Gasphasenabscheidung führt insbesondere zu einer durchgehenden und ausreichend dicken Isolationsschicht innerhalb der Durchgangsöffnung.

Ein Vorteil des Verfahrens ist somit, dass durch das beidseitige vollflächige Beschichten mittels Gasphasenabscheidung eine zuverlässige Isolationsschicht innerhalb einer Durchgangsöffnung ohne großen zusätzlichen Aufwand erzeugt wird.

Mittels der Gasphasenabscheidung ist es außerdem auf einfache Weise möglich Schichten mit unterschiedlichen Materialien oder unterschiedlicher Stöchiometrie nacheinander aufzubringen.

Ein Schichtsystem aus mindestens zwei unterschiedlichen Isolationsschichten ermöglicht es wiederum die Pinhole-Dichte zu reduzieren und/oder die Haftung einer folgenden Metallisierung zu erhöhen.

Gemäß einer Weiterbildung wird die dielektrische Isolationsschicht mittels plasmaunterstützter Gasphasenabscheidung aufgebracht. Dieses Abscheidungsverfahren ist bei geringeren Temperaturen von nur ca. 100° bis 500°C durchführbar.

In einer anderen Ausführungsform weist die aufgebrachte dielektrisch Isolationsschicht auf der Seitenwand der Durchgangsöffnung eine Schichtdicke von mindestens 10 nm auf.

Es hat sich herausgestellt, dass eine Schichtdicke von 10 nm ausreicht, um eine zuverlässige Isolation zu erreichen. Dies ist insbesondere der Fall, wenn die Pinhole-Dichte der Isolationsschicht möglichst gering ist, beispielsweise durch ein Schichtsystem aus mindestens zwei Schichten als Isolationsschicht und wenn die Durchgangsöffnung frei von Unterätzungen ist.

Erfindungsgemäß beinhaltet die dielektrische Isolationsschicht SiOₓ und/oder SiNₓ. Die aufgebrachte Isolationsschicht kann insbesondere ein Schichtsystem aus mindestens zwei Schichten aus SiOₓ und/oder SiNₓ aufweisen. Die mindestens zwei Schichten unterscheiden sich beispielsweise hinsichtlich des Materials oder hinsichtlich der Stöchiometrie.

In einer anderen Weiterbildung wird die dielektrische Isolationsschicht zuerst auf die Oberseite der Halbleiterscheibe aufgebracht, dann die Halbleiterscheibe gedreht und dann die dielektrische Isolationsschicht auf die Unterseite aufgebracht. Das Drehen stellt eine einfache Möglichkeit dar, in einer bestehenden Vorrichtung für die Gasphasenabscheidung ein beidseitiges Beschichten einer Halbleiterscheibe umzusetzen.

Gemäß einer Weiterbildung weist die Durchgangsöffnungen der bereitgestellten Halbleiterscheibe an einem an die Oberseite der Halbleiterscheibe angrenzenden Rand einen ersten Durchmesser von höchstens 1 mm und mindestens 50 µm und an einem an die Unterseite der Halbleiterscheibe angrenzenden Rand einen zweiten Durchmesser von höchstens 1 mm und von mindestens 50 µm auf.

Vorzugsweise weist die bereitgestellte Halbleiterscheibe eine Gesamtdicke von höchstens 300 µm und von mindestens 90 µm auf.

In einer anderen Ausführungsform wird nach dem Aufbringen der dielektrischen Isolationsschicht die dielektrischen Isolationsschicht erst auf der Oberseite und dann auf der Unterseite oder erst auf der Unterseite und dann auf der Oberseite strukturiert oder die Unterseite und die Oberseite werden gleichzeitig strukturiert.

Gemäß einer Weiterbildung wird die dielektrische Isolationsschicht nasschemisch strukturiert, wobei jeweils eine erste Lackschicht aufgebracht, ausgehärtet und belichtet und entwickelt wird und / oder ein zu der ersten Lackschicht unterschiedliches organisches Material mittels eines Siebdruckverfahrens oder mittels eines Inkjet-Druckverfahrens strukturiert aufgebracht wird.

In einer weiteren Weiterbildung wird vor dem Aufbringen der ersten Lackschicht ein Haftvermittler, z.B. titanhaltig, aufgebracht.

Erfindungsgemäß wird nach dem Aufbringen der ersten Lackschicht und vor dem Belichten im Bereich des Durchgangslochs eine zweite Lackschicht aufgebracht. Alternativ wird ein anderes HF-resistentes organisches Füllmaterial, z.B. ein Wachs oder Harz oder Kleber oder Thermoplast, als weitere Schutzschicht im Bereich des Durchgangslochs aufgebracht. Die Lackschicht oder das andere organische Füllmaterial wird gemäß einer Weiterbildung mittels eins Druckverfahrens, z.B. Siebdruck, aufgebracht.

Gemäß einer Weiterbildung ist die Isolationsschicht als Schichtsystem aus einer erste Schicht und mindestens einer zweiten Schicht ausgebildet.

Die erste Schicht ist vor der zweiten Schicht aufgebracht.

Es versteht sich, dass die beiden Schichten jeweils mittels Gasphasenabscheidung aufgebracht sind.

Hierbei ist zuerst die erste Schicht auf die Oberseite der Halbleiterscheibe und auf die Unterseite der Halbleiterscheibe aufgebracht.

Anschließend ist die zweite Schicht auf die Oberseite der Halbleiterscheibe und die Unterseite der Halbleiterscheibe aufgebracht.

Alternativ sind in einem ersten Schritt zuerst nacheinander die erste Schicht und die zweite Schicht auf die Oberseite aufgebracht und anschließend wieder nacheinander die erste Schicht und die zweite Schicht auf die Unterseite der Halbleiterscheibe aufgebracht.

Durch eine Kombination von zwei oder mehr Schichten aus unterschiedlichen Materialien oder zumindest mit unterschiedlicher Stöchiometrie als Isolationsschicht lässt sich die Pinhole-Dichte deutlich reduzieren. Hierdurch erhöht sich die Integrität der Isolationsschicht und die Zuverlässigkeit des Bauelements insgesamt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen. die
- Figur 1: eine Ansicht einer ersten erfindungsgemäßen Ausführungsform eines Passivierungsverfahrens für eine Durchgangsloch einer Halbleiterscheibe,
- Figur 2: eine Aufsicht auf eine gemäß des Passivierungsverfahrens passivierten Durchgangslochs einer Halbleiterscheibe
- Figur 3: eine Halbleiterscheibe.

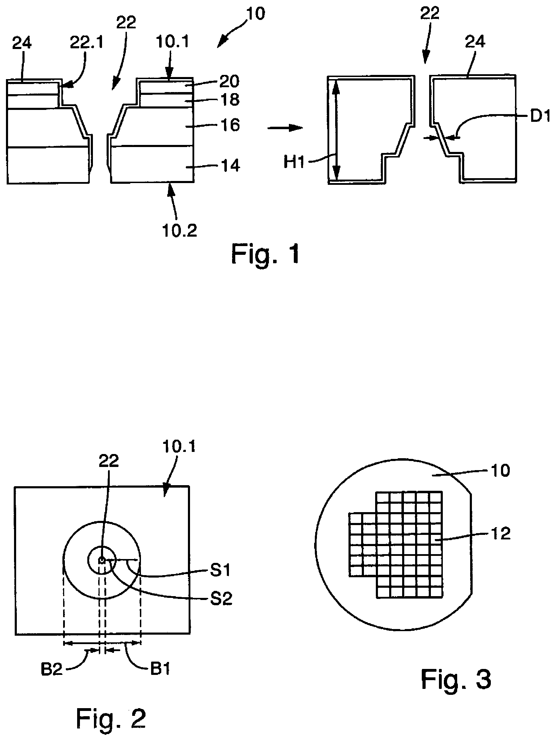

Die Abbildung der Figur 1 veranschaulich eine erste erfindungsgemäße Ausführungsform eines Passivierungsverfahrens für ein Durchgangsloch einer Halbleiterscheibe.

Es wird eine stapelförmige Halbleiterscheibe 10 mit einer Oberseite 10.1, einer Unterseite 10.2 und einer von der Oberseite 10.1 bis zu der Unterseite 10.2 reichenden Durchgangsöffnung 22 mit einer zusammenhängenden Seitenwand 22.1 und einem im Querschnitt ovalen, z.B. kreisförmigen, Umfang bereitgestellt.

Die Unterseite 10.2 wird von einem Ge-Substrat 14 ausgebildet, gefolgt von einer Ge-Teilzelle 16 und zwei III-V-Teilzellen.

Die Durchgangsöffnung 22 weist an der Oberseite 10.1 der Halbleiterscheibe 10 einen ersten Durchmesser B1 und an der Unterseite 10.2 einen zweiten Durchmesser B2 auf, wobei der zweite Durchmesser B2 kleiner als der erste Durchmesser B1 ist.

Außerdem weist das Durchgangsloch zwei stufenförmige umlaufende Absätze auf, wobei die Absätze jeweils von der Oberseite 10.1 aus gesehen durch eine sprunghafte Abnahme des Durchmessers des Durchgangslochs gebildet werden. Der erste Absatz weist eine von einer Oberseite der Ge-Teilzelle ausgebildete umlaufende Absatzfläche auf.

Der zweite Absatz befindet sich im Bereich der Ge-Teilzelle unterhalb eines pn-Übergangs der Ge-Teilzelle.

Die Oberseite 10.1 der Halbleiterscheibe 10 sowie ein sich an die Oberseite 10.1 anschließender Teil der Seitenfläche 22.1 der Durchgangsöffnung 22 wird mittels chemischer Gasphasenabscheidung mit einer dielektrischen Isolationsschicht 24 beschichtet.

Anschließend wird die Halbleiterscheibe 10.1 gedreht und die Unterseite 10.2 sowie ein sich an die Unterseite 10.2 anschließender Teil der Seitenfläche 22.1 der Durchgangsöffnung 22 mittels chemischer Gasphasenabscheidung mit der dielektrischen Isolationsschicht 24 beschichtet.

Eine Schichtdicke D1 der dielektrischen Isolationsschicht 24 innerhalb der Durchgangsöffnung beträgt mindestens 10 nm.

In der Abbildung der Figur 2 ist eine weitere Ausführungsform dargestellt. Im Folgenden werden nur die Unterschiede zu der Abbildung der Figur 1 erläutert.

In der Aufsicht auf die Halbleiterscheibenoberseite 10.1 mit dem Durchgangsloch 22 sind die beiden Absätze bzw. Absatzflächen zu erkennen. Die Absatzfläche des ersten stufenförmigen Absatzes weist eine Auftrittstiefe S1 auf. Der zweite Absatz weist eine Auftrittsfläche S2 auf.

In der Abbildung der Figur 3 ist eine weitere Ausführungsform dargestellt. Im Folgenden werden nur die Unterschiede zu der Abbildung der Figur 1 oder 2 erläutert.

Das Passivierungsverfahren wird auf Wafer-level durchgeführt, d.h. die Halbleiterscheibe umfasst mehrere Solarzellenstapel 12, welche in der Aufsicht auf die Halbleiterscheibenoberseite 10.1 in der Fig. 3 zu erkennen ist.

## Patentansprüche

1. Passivierungsverfahren für ein Durchgangsloch einer Halbleiterscheibe (10) mindestens umfassend die Schritte:
- Bereitstellen einer Halbleiterscheibe (10) mit einer Oberseite (10.1), einer Unterseite (10.2) und umfassend mehrere Solarzellenstapel (12),
- wobei jeder Solarzellenstapel (12) ein die Unterseite (10.1) der Halbleiterscheibe (10) ausbildendes Ge-Substrat (14), eine Ge-Teilzelle (16), mindestens zwei III-V-Teilzellen (18, 20) in der genannten Reihenfolge und mindestens eine von der Oberseite (10.1) zu der Unterseite (10.2) der Halbleiterscheibe (10) reichende Durchgangsöffnung (22) mit zusammenhängender Seitenwand (22.1) und einem im Querschnitt ovalen Umfang aufweist,
- die Durchgangsöffnung (22) an der Oberseite (10.1) der Halbleiterscheibe (10) einen ersten Durchmesser (B1) und an der Unterseite (10.2) einen zweiten Durchmesser (B2) aufweist, wobei der zweite Durchmesser (B2) kleiner als der erste Durchmesser (B1) ist,
- Aufbringen einer dielektrischen Isolationsschicht (24) mittels chemischer Gasphasenabscheidung auf die Oberseite (10.1) der Halbleiterscheibe (10), die Unterseite (10.2) der Halbleiterscheibe (10) und die Seitenwand (22.1) der Durchgangsöffnung (22), wobei
die dielektrische Isolationsschicht (24) SiOₓ und/oder SiNₓ beinhaltet,
- zur Strukturierung der Isolationsschicht (24) wird nach einem Aufbringen einer ersten Lackschicht und vor einem Belichten in dem Bereich des Durchgangslochs eine zweite Lackschicht oder ein anderes HF-resistentes organisches Füllmaterial aufgebracht.

2. Verfahren nach Anspruch 1, **dadurch gekennzeichnet, dass** die dielektrische Isolationsschicht (24) mittels plasmaunterstützter Gasphasenabscheidung aufgebracht wird.

3. Verfahren nach Anspruch 1 oder 2, **dadurch gekennzeichnet, dass** die aufgebrachte dielektrisch Isolationsschicht (24) auf der Seitenwand (22.1) der Durchgangsöffnung (22) eine Schichtdicke (D1) von mindestens 10 nm.

4. Verfahren nach einem der vorstehenden Ansprüche, **dadurch gekennzeichnet, dass** die dielektrische Isolationsschicht (24) zuerst auf die Oberseite (10.1) der Halbleiterscheibe (10) aufgebracht wird, dann die Halbleiterscheibe (10) gedreht wird und dann die dielektrische Isolationsschicht (24) auf die Unterseite (10.2) aufgebracht wird.

5. Verfahren nach einem der vorstehenden Ansprüche, **dadurch gekennzeichnet, dass** die Durchgangsöffnungen (22) der bereitgestellten Halbleiterscheibe (10)
- an einem an die Oberseite (10.1) der Halbleiterscheibe (10) angrenzenden Rand einen ersten Durchmesser (B1) von höchstens 1 mm und mindestens 50 µm aufweist und
- an einem an die Unterseite (10.2) der Halbleiterscheibe (10) angrenzenden Rand einen zweiten Durchmesser (B2) von höchstens 1 mm und von mindestens 50 µm aufweist, wobei
- die bereitgestellte Halbleiterscheibe (10) eine Gesamtdicke (H1) von höchstens 300 µm und von mindestens 90 µm aufweist.

6. Verfahren nach einem der vorstehenden Ansprüche, **dadurch gekennzeichnet, dass** nach dem Aufbringen der dielektrischen Isolationsschicht (24) die dielektrischen Isolationsschicht (24) erst auf der Oberseite (10.1) und dann auf der Unterseite (10.2) oder erst auf der Unterseite (10.2) und dann auf der Oberseite (10.1) strukturiert wird oder die Unterseite (10.2) und die Oberseite (10.1) werden gleichzeitig strukturiert.

7. Verfahren nach Anspruch 6, **dadurch gekennzeichnet, dass** die dielektrische Isolationsschicht (24) nasschemisch strukturiert wird, wobei jeweils eine erste Lackschicht aufgebracht, ausgehärtet, belichtet und entwickelt wird und / oder ein zu der ersten Lackschicht unterschiedliches organisches Material mittels eines Siebdruckverfahrens oder mittels eines Inkjet-Druckverfahrens strukturiert aufgebracht wird.

8. Verfahren nach einem der vorstehenden Ansprüche, **dadurch gekennzeichnet, dass** die Isolationsschicht (24) als Schichtsystem aus einer erste Schicht und mindestens einer zweiten Schicht ausgebildet wird, wobei die erste Schicht vor der zweiten Schicht aufgebracht wird.

9. Verfahren nach einem der vorstehenden Ansprüche, **dadurch gekennzeichnet, dass** bei der Durchgangsöffnung (22) zwei stufenförmige umlaufende Absätze ausgebildet werden, wobei die Absätze jeweils von der Oberseite (10.1) aus gesehen durch eine sprunghafte Abnahme des Durchmessers der Durchgangsöffnung (22) gebildet werden und der erste Absatz eine von einer Oberseite der Ge-Teilzelle (16) ausgebildete umlaufende Absatzfläche aufweist und der zweite Absatz sich im Bereich der Ge-Teilzelle (16) unterhalb eines pn-Übergangs der Ge-Teilzelle ausgebildet wird.

10. Verfahren nach Anspruch 1, **dadurch gekennzeichnet, dass** ein zu der ersten Lackschicht unterschiedliches Material mittels eines Siebdruckverfahrens oder mittels eines Injekt- Druckverfahrens strukturiert aufgebracht wird.

## Claims

1. Passivation method for a passage opening of a semiconductor wafer (10) comprising the steps:
- providing a semiconductor wafer (10) with an upper side (10.1), a lower side (10.2) and a plurality of solar cell stacks (12),
- wherein each solar cell stack (12) comprises a Ge substrate (154) forming the lower side (10.1) of the semiconductor wafer (10), a Ge sub-cell (16), at least two III-V subcells (18, 20) in the stated sequence and at least one passage opening (22), which extends from the upper side (10.1) to the lower side (10.2) of the semiconductor wafer (10), with continuous side wall (22.1) and a circumference oval in cross-section,
- the passage opening (22) has a first diameter (B1) at the upper side (10.1) of the semiconductor wafer (10) and a second diameter (B2) at the lower side (10.2), wherein the second diameter (B2) is smaller than the first diameter (B1),
- applying a dielectric insulation layer (24) by means of chemical gaseous phase deposition on the upper side (10.1) of the semiconductor wafer (10), the lower side (10.2) of the semiconductor wafer (10) and the side wall (22.1) of the passage opening (22), wherein the dielectric insulation layer (24) contains SiOₓ and/or SiNₓ,
- after application of a first lacquer layer and before illumination in the region of the passage opening a second lacquer layer or another HF-resistant organic filler material is applied for structuring of the insulation layer (24).

2. Method according to claim 1, **characterised in that** the dielectric insulation layer (24) is applied by means of plasma-assisted gaseous phase deposition.

3. Method according to claim 1 or 2, **characterised in that** the applied dielectric insulation layer (24) on the side wall (22.1) of the passage opening (22) has a layer thickness (D1) of at least 10 nm.

4. Method according to any one of the preceding claims, **characterised in that** the dielectric insulation layer (24) is firstly applied to the upper side (10.1) of the semiconductor wafer (10), then the semiconductor wafer (10) is turned and then the dielectric insulation layer (24) is applied to the lower side (10.2).

5. Method according to any one of the preceding claims, **characterised in that** the passage opening (22) of the provided semiconductor wafer (10) has
- a first diameter (B1) of at most 1 mm and at least 50 µm at an edge adjoining the upper side (10.1) of the semiconductor wafer (10) and
- a second diameter (B2) of at most 1 mm and at least 50 µm at an edge adjoining the lower side (10.2) of the semiconductor wafer (10), wherein
- the provided semiconductor wafer (10) has an overall thickness (H1) of at most 300 µm and at least 90 µm.

6. Method according to any one of the preceding claims, **characterised in that** after application of the dielectric insulation layer (24) the dielectric insulation layer (24) is structured firstly on the upper side (10.1) and then on the lower side (10.2) or firstly on the lower side (10.2) and then on the upper side (10.1) or the lower side (10.2) and the upper side (10.1) are structured simultaneously.

7. Method according to claim 6, **characterised in that** the dielectric insulation layer (24) is structured by a wet-chemical procedure, wherein in each instance a first lacquer layer is applied, hardened, illuminated and developed and/or an organic material different from the first lacquer layer is applied in structured form by means of a screen-printing method or by means of an ink-jet printing method.

8. Method according to any one of the preceding claims, **characterised in that** the insulation layer (24) is formed as a layer system from a first layer and at least one second layer, wherein the first layer is applied before the second layer.

9. Method according to any one of the preceding claims, **characterised in that** two step-shaped encircling shoulders are formed at the passage opening (22), wherein the shoulders as each seen from the upper side (10.1) are formed by an abrupt reduction in the diameter of the passage opening (22) and the first shoulder has an encircling shoulder surface formed by an upper side of the Ge sub-cell (16) and the second shoulder is formed in the region of the Ge sub-cell (16) below a pn transition of the Ge sub-cell.

10. Method according to claim 1, **characterised in that** a material different from the first lacquer layer is applied in structured form by means of a screen-printing method or by means of an ink-jet printing method.

## Revendications

1. Procédé de passivation pour un trou traversant d'une plaque semi-conductrice (10) comprenant au moins les étapes suivantes :
- fourniture d'une plaque semi-conductrice (10) avec une face supérieure (10.1), une face inférieure (10.2) et comprenant plusieurs piles de cellules solaires (12),
- chaque pile de cellules solaires (12) comprenant un substrat en Ge (14) formant la face inférieure (10.1) de la plaque semi-conductrice (10), une cellule partielle Ge (16), au moins deux cellules partielles III-V (18, 20) dans l'ordre indiqué et au moins une ouverture traversante (22) s'étendant de la face supérieure (10.1) à la face inférieure (10.2) de la plaque semi-conductrice (10) avec une paroi latérale continue (22.1) et un pourtour de section ovale,
- l'ouverture traversante (22) présente un premier diamètre (B1) sur la face supérieure (10.1) de la plaque semi-conductrice (10) et un deuxième diamètre (B2) sur la face inférieure (10.2), le deuxième diamètre (B2) étant inférieur au premier diamètre (B1),
- application d'une couche isolante diélectrique (24) par dépôt chimique en phase vapeur sur la face supérieure (10.1) de la plaque semi-conductrice (10), la face inférieure (10.2) de la plaque semi-conductrice (10) et la paroi latérale (22.1) de l'ouverture de passage (22), la couche isolante diélectrique (24) contenant du SiOx et/ou du SiNX,
- pour structurer la couche isolante (24), après l'application d'une première couche de vernis et avant l'exposition à la lumière, une deuxième couche de vernis ou un autre matériau de remplissage organique résistant aux hautes fréquences est appliqué dans la zone du trou de passage.

2. Procédé selon la revendication 1, **caractérisé en ce que** la couche isolante diélectrique (24) est appliquée au moyen d'un dépôt en phase vapeur assisté par plasma.

3. Procédé selon la revendication 1 ou 2, **caractérisé en ce que** la couche isolante diélectrique (24) appliquée sur la paroi latérale (22.1) de l'ouverture traversante (22) a une épaisseur (D1) d'au moins 10 nm.

4. Procédé selon l'une des revendications précédentes, **caractérisé en ce que** la couche isolante diélectrique (24) est d'abord appliquée sur la face supérieure (10.1) de la plaque semi-conductrice (10), puis la plaque semi-conductrice (10) est retournée et la couche isolante diélectrique (24) est ensuite appliquée sur la face inférieure (10.2).

5. Procédé selon l'une des revendications précédentes, **caractérisé en ce que** l'ouverture traversante (22) de la plaque semi-conductrice (10) fournie
- sur un bord adjacent à la face supérieure (10.1) de la plaque semi-conductrice (10), présente un premier diamètre (B1) d'au plus 1 mm et d'au moins 50 µm, et
- sur un bord adjacent à la face inférieure (10.2) de la tranche de semi-conducteur (10), présente un deuxième diamètre (B2) d'au plus 1 mm et d'au moins 50 µm,
- la plaque semi-conductrice (10) fournie présente une épaisseur totale (H1) d'au plus 300 µm et d'au moins 90 µm.

6. Procédé selon l'une des revendications précédentes, **caractérisé en ce qu'**après l'application de la couche isolante diélectrique (24), la couche isolante diélectrique (24) est d'abord structurée sur la face supérieure (10.1), puis sur la face inférieure (10.2) ou d'abord sur la face inférieure (10.2) puis sur la face supérieure (10.1), ou bien la face inférieure (10.2) et la face supérieure (10.1) sont structurées simultanément.

7. Procédé selon la revendication 6, **caractérisé en ce que** la couche isolante diélectrique (24) est structurée par voie chimique humide, une première couche de vernis étant appliquée, durcie, exposée à la lumière et développée et/ou un matériau organique différent de la première couche de vernis étant appliqué de manière structurée au moyen d'un procédé de sérigraphie ou d'un procédé d'impression à jet d'encre.

8. Procédé selon l'une des revendications précédentes, **caractérisé en ce que** la couche isolante (24) est formée comme un système de couches composé d'une première couche et d'au moins une deuxième couche, la première couche étant appliquée avant la deuxième couche.

9. Procédé selon l'une des revendications précédentes, **caractérisé en ce que** deux décrochements périphériques en forme d'échelons sont formés au niveau de l'ouverture de passage (22), les décrochements étant chacun formés par une diminution brusque du diamètre de l'ouverture de passage (22) vue depuis la face supérieure (10.1), et le premier échelon présente une surface d'échelon périphérique formée par un côté supérieur de la cellule partielle Ge (16) et le deuxième échelon est formé dans la zone de la cellule partielle Ge (16) en dessous d'une jonction pn de la cellule partielle Ge.

10. Procédé selon la revendication 1, **caractérisé en ce qu'**un matériau différent de la première couche de vernis est appliqué de manière structurée au moyen d'un procédé de sérigraphie ou d'un procédé d'impression par injection.
